# EUROPÄISCHE PATENTSCHRIFT

(11) **EP 4 086 714 B1**
(45) Veröffentlichungstag und Bekanntmachung des Hinweises auf die Patenterteilung: **03.12.2025**
(21) Anmeldenummer: 22181101.1
(22) Anmeldetag: 20.01.2016
(51) Int. Cl.: G05B 19/042

(54) **ELEKTRONISCHES SICHERHEITSSCHALTGERÄT**
ELECTRONIC SAFETY LOCK
APPAREIL ÉLECTRONIQUE DE COMMUTATION DE SÉCURITÉ

(30) Priorität: 23.01.2015 DE 102015101023
(43) Veröffentlichungstag der Anmeldung: 09.11.2022
(62) Teilanmeldung aus: 16701277.2
(73) Patentinhaber: Pilz GmbH & Co. KG, 73760 Ostfildern (DE)
(72) Erfinder: Godau, Thorsten, 73760 Ostfildern (DE); Fröhlich, Norbert, 73760 Ostfildern (DE); Holzäpfel, Matthias, 73760 Ostfildern (DE); Schwenkel, Hans, 73760 Ostfildern (DE)
(74) Vertreter: Witte, Weller & Partner Patentanwälte mbB

(56) Entgegenhaltungen:
- DE-A1- 10 053 820
- US-A1- 2012 193 681
- US-A1- 2013 176 763
- US-A1- 2013 231 767

## Beschreibung

Die vorliegende Erfindung betrifft ein elektronisches Sicherheitsschaltgerät mit zumindest einem ersten und einem zweiten Signalverarbeitungskanal, denen zur Signalverarbeitung Eingangssignale zuführbar sind und die verarbeitete Ausgangssignale bereitstellen, wobei der erste und der zweite Signalverarbeitungskanal dazu eingerichtet sind, die zugeführten Eingangssignale redundant zueinander zu verarbeiten, wobei der erste und der zweite Signalverarbeitungskanal jeweils mithilfe integrierter Halbleiterstrukturen aufgebaut sind, und wobei der erste Signalverarbeitungskanal monolithisch auf einem ersten Halbleitersubstrat angeordnet ist und der zweite Signalverarbeitungskanal monolithisch auf einem zweiten Halbleitersubstrat angeordnet ist.

Ein derartiges Sicherheitsschaltgerät sowie ein solches Verfahren sind beispielsweise aus der US 2013/0231767 A1 bekannt.

US 2013/0231767 A1 zeigt ein Mehr-Chip-Modul mit einem ersten Chip und einem zweiten Chip, die jeweils auf einem eigenen Substrat ("Die") gefertigt sind. Der erste Chip ist ein Steuerprozessor zum Erzeugen eines Signals zum Steuern eines industriellen Prozesses. Der zweite Chip ist ein Überwachungsprozessor. Der Ausfall eines Prozessors wird von dem jeweils anderen Prozessor erkannt, wobei jeder Prozessor über eine I/O-Schnittstelle verfügt, um in Reaktion auf einen Fehler den industriellen Prozess in einen sicheren Zustand zu überführen. Zudem sind der erste Chip und der zweite Chip mit unterschiedlichen Verfahrenstechniken hergestellt.

Sicherheitsschaltgeräte der eingangs genannten Art werden vor allem im industriellen Bereich eingesetzt und sind in nahezu allen Bereichen des Maschinen- und Anlagenbaus anzutreffen. Sicherheitsschaltgeräte führen definierte Sicherheitsfunktionen aus. Beispielsweise sorgen sie für ein gesteuertes und damit sicheres Stillsetzen einer Bewegung einer technischen Anlage oder dienen der Positionsüberwachung von beweglichen Schutzeinrichtungen. Grundsätzlich sind Sicherheitsschaltgeräte dazu ausgebildet, im Fehlerfall und bei Verletzung von Schutzbereichen eine sichere und zuverlässig erfolgende Reaktion einzuleiten.

Es versteht sich, dass an die Fehlersicherheit solcher Sicherheitsschaltgeräte sehr hohe Anforderungen gestellt werden. So müssen in der Regel Sicherheitsschaltgeräte zunächst eine entsprechende Zulassung durch eine zulässige Aufsichtsbehörde durchlaufen, bevor sie im industriellen Bereich verwendet werden dürfen. In Deutschland führt beispielsweise die Berufsgenossenschaft oder der TÜV solche Zulassungen durch. Einschlägige Normen zur Funktionalen Sicherheit sind beispielsweise die DIN EN 61508 zur Entwicklung von elektrischen, elektronischen und programmierbar elektronischen (E/E/PE) Systemen oder die EN 61511 zur Entwicklung von sicherheitstechnischen Systemen für die Prozessindustrie. U.a. legen diese Normen Sicherheitsanforderungsstufen (SIL) fest, die der Beurteilung von (E/E/PE)-Systemen in Bezug auf die Zuverlässigkeit von Sicherheitsfunktionen dienen. Sicherheitsschaltgeräte im Sinne der vorliegenden Erfindung sind solche Geräte, die mindestens den Anforderungen eines SIL 2 genügen.

Eine an sich bekannte und häufig eingesetzte Maßnahme zum Erreichen dieser erforderlichen Fehlersicherheit ist es, das Sicherheitsschaltgerät mehrkanalig-redundant aufzubauen, wobei sich zumindest zwei Signalverarbeitungskanäle gegenseitig überwachen. Tritt in einem der Signalverarbeitungskanäle ein Fehler auf, ist der zweite Signalverarbeitungskanal in der Lage, diesen zu erkennen und einen für Personen im Bereich der Maschinenanlage gefahrlosen Zustand herbeizuführen. Besondere Aufmerksamkeit muss bei diesem Vorgehen auf mögliche Fehlerursachen gelegt werden, die mehrere oder alle redundante Signalverarbeitungskanäle in gleicher Weise beeinflussen (sogenannte Common-Cause-Fehler), da ansonsten die erforderliche Fehlersicherheit nicht gewährleistet werden kann.

Ein häufig praktiziertes Vorgehen bei der Zulassung von Sicherheitsschaltgeräten durch die zuständigen Aufsichtsbehörden ist es, dass der Konstrukteur oder Hersteller des Sicherheitsschaltgerätes eine eingehende und detaillierte Fehlerbetrachtung vorlegen muss, in der jeder denkbare Fehler erfasst ist. Darin muss bewiesen werden, dass das Sicherheitsschaltgerät auch bei Auftreten des jeweiligen Fehlers in zuverlässiger Weise einen gefahrlosen Zustand für Personen herbeiführen kann. Eine derartige Betrachtung ist insbesondere bei komplexen Sicherheitsschaltgeräten mit zahlreichen Funktionen sehr aufwendig, was sich nachteilig auf die Kosten der Entwicklung und Herstellung auswirkt. Hinzu kommt, dass diese Fehlerbetrachtung auch bei geringen Änderungen am Aufbau oder in der Struktur des Sicherheitsschaltgeräts wiederholt werden muss, da beispielsweise allein durch eine räumlich unterschiedliche Anordnung von an sich gleichen Bauelementen neue Fehlerquellen erzeugt werden können.

DE 100 53 820 A1 schlägt aus diesem Grund ein elektronisches Sicherheitsschaltgerät vor, bei dem wesentliche Bestandteile der redundanten Signalverarbeitungskanäle aus integrierten Halbleiterschaltkreisen gebildet werden, die auf einem einzelnen Halbleiterchip angeordnet sind. Diese sogenannte On-Chip-Redundanz, bei der unter Beibehaltung der getrennten Signalverarbeitungskanäle ein einziges integriertes und unveränderbares Bauteil bereitgestellt wird, hat den Vorteil, dass die für die Zulassung durch die Aufsichtsbehörde erforderliche Fehlerbetrachtung nur einmalig durchgeführt werden muss. Spätere Überprüfungen können sich anschließend darauf beschränken, die Einhaltung der bei der Entwicklung des Halbleiterchips festgelegten Spezifikationen, insbesondere die Einhaltung von vorgesehenen räumlichen Abmessungen und verwendeten Materialien, quantitativ zu überprüfen.

Aufgrund der besondere Architekturanforderungen, die bei der Konstruktion und Entwicklung von Halbleiterchip mit On-Chip-Redundanz berücksichtig werden müssen, sind derartige Chips jedoch oft spezielle Einzelanfertigungen und in der Regel um ein Vielfaches teurer als gängige Halbleiterchips mit redundanten Strukturen, wie beispielsweise moderne Multi-Core-Prozessoren, die für Parallel-Processing verwendet werden. So müssen bei Halbleiterchips mit On-Chip-Redundanz, die für sicherheitskritische Anwendungen verwendet werden, für jeden Kanal und für jedes Überwachungselement, wie zum Beispiel einen Watchdog, separate physikalische Blöcke auf dem Halbleitersubstrat gebildet werden, die in einem definierten Abstand zueinander angeordnet sind und sich so nicht gegenseitig beeinflussen können. Darüber hinaus muss jeder Kanal eigene getrennte Eingänge und Ausgänge besitzen, die nicht durch einen der anderen Blöcke hindurchgeführt werden dürfen. Das Chipdesign wird hierdurch besonders komplex und die integrierten Schaltkreise beanspruchen in der Regel überdurchschnittlich viel Fläche auf einem Halbleitersubstrat, wodurch wiederum die Kosten eines einzelnen Chips steigen.

Zusätzlich gibt es Anwendungsbereiche in der Sicherheitstechnik, die die Verwendung von Systemen mit On-Chip-Redundanz grundsätzlich ausschließen. So dürfen beispielsweise bei der Verwendung von berührungslos wirkenden Schutzeinrichtungen (BWS) keine Systeme eingesetzt werden, bei denen die Signalverarbeitungseinheiten der einzelnen Kanäle auf einem Halbleitersubstrat angeordnet sind. Solche Schutzeinrichtungen können somit nach heutigem Stand nicht mit bekannten On-Chip-Redundanz-Systemen verwendet werden.

Weiteren Stand der Technik zeigen US 2012/0193681 A1 und US 2013/0176763 A1, die jeweils Halbleitervorrichtungen mit dreidimensionalen Strukturen zeigen. Keine der gezeigten Halbleitervorrichtungen betrifft jedoch Halbleiterchips für Sicherheitsschaltgeräte mit On-Chip-Redundanz, die für sicherheitskritische Anwendungen verwendet werden können.

Es ist daher eine Aufgabe der vorliegenden Erfindung, ein Sicherheitsschaltgerät der eingangs genannten Art anzugeben, das kleinbauend, kostengünstig, effizient und für alle gängigen Schutzeinrichtungen verwendbar ist.

Gemäß einem Aspekt der vorliegenden Erfindung wird diese Aufgabe durch ein elektronisches Sicherheitsschaltgerät der eingangs genannten Art gelöst, dadurch gekennzeichnet, dass das erste Halbleitersubstrat und das zweite Halbleitersubstrat zu einem Stapel zusammengesetzt sind und so ein einzelnes, einstückiges elektronisches Bauteil bilden, wobei der Stapel ein weiteres Halbleitersubstrat aufweist, wobei das erste Halbleitersubstrat eine erste Signalverarbeitungseinheit, das zweite Halbleitersubstrat eine zweite Signalverarbeitungseinheit und das weitere Halbleitersubstrat eine Steuer- und Speicherstruktur aufweist, und wobei die erste Signalverarbeitungseinheit und die zweite Signalverarbeitungseinheit mit der Steuer- und Speicherstruktur gekoppelt sind.

Es ist somit eine Idee der vorliegenden Erfindung, im Gegensatz zu bekannten On-Chip-Redundanz-Systemen zwei getrennte Halbleitersubstrate zu verwenden, die übereinandergestapelt werden und so ein einzelnes elektronisches Bauelement bilden, in dem die integrierten Schaltkreise des einen Signalverarbeitungskanals eine erste Ebene bilden, die über einer entsprechenden zweiten Ebene mit den integrierten Schaltkreisen des anderen Signalverarbeitungskanals liegt. Die zwei getrennten Halbleitersubstrate liegen in zwei zueinander parallelen Ebenen, die in einer Richtung orthogonal zu den Ebenen versetzt zueinander sind. Hierbei können die einzelnen integrierten Schaltkreise auf dem jeweiligen Halbleitersubstrat unabhängig voneinander ausgestaltet werden, ohne dass die besonderen Architekturanforderungen, die an integrierte Schaltkreise mit On-Chip-Redundanz gestellt werden, berücksichtigt werden müssen. So kann das Design der integrierten Schaltkreise vereinfacht werden, indem beispielsweise auf ein Standarddesign für integrierte Verarbeitungseinheiten zurückgegriffen wird. Darüber hinaus können die integrierten Schaltkreise effektiv und platzsparenden auf dem jeweiligen Halbleitersubstrat angeordnet werden, ohne spezielle sicherheitstechnische Anforderungen einhalten zu müssen, wodurch wiederum Kosten bei der Fertigung eingespart werden können.

Die Verwendung von zwei zueinander getrennten Halbleitersubstraten hat darüber hinaus den Vorteil, dass ein derartiges elektronisches Sicherheitsschaltgerät auch für eine sicherheitstechnische Anwendung verwendet werden kann, die aufgrund der Normenlage bisher die Verwendung von Systemen mit On-Chip-Redundanz nicht erlaubt hat. So kann ein solches Sicherheitsschaltgerät insbesondere auch für berührungslos wirkende Schutzeinrichtungen verwendet werden, bei denen bisher auf elektronische Sicherheitsschaltgeräte zurückgegriffen werden musste, deren Signalverarbeitung vollständig getrennt durch separate Bauteile und Halbleiterchips erfolgt. Das neue Sicherheitsschaltgerät ist damit vielseitig und flexible mit gängigen Schutzeinrichtungen verwendbar.

Darüber hinaus besitzt das neue Sicherheitsschaltgerät den Vorteil, dass der Stapel aus den zwei Halbleitersubstraten zu einem einstückigen Bauteil zusammengefasst werden kann. Einstückig bedeutet in diesem Zusammenhang insbesondere, dass das fertige elektronische Bauteil im Nachhinein nicht mehr veränderbar ist. Mit anderen Worten ist die Struktur des elektronischen Bauteils bereits bei der Entwicklung und Konstruktion in unveränderbarer Form festgelegt, aber das endgültige Bauteil wird im Verlauf des Herstellungsprozesses aus separaten Halbleitersubstraten zu dem einstückigen Bauteil zusammengefügt. Vorzugsweise sind die Halbleitersubstrate in dem Stapel direkt aufeinandergesetzt und dauerhaft miteinander zu dem einstückigen Bauteil verbunden. Besonders vorteilhaft ist es, wenn das einstückige Bauteil nach dem Zusammensetzen der Halbleitersubstrate zu dem Stapel mit einer Vergussmasse umhüllt wird, die sich formschlüssig um die Halbleitersubstrate legt, so dass ein integriertes, mehrkanaliges Logikbauteil entsteht, das beispielsweise in automatisierten Bestückungsprozessen auf einer Leiterplatte positioniert werden kann. Eine Fehlerbetrachtung bei der Zulassung durch eine Aufsichtsbehörde muss vorteilhaft nur einmalig vorgenommen werden und spätere Überprüfungen können sich auf die Einhaltungen der notwendigen Konstruktionsvorschriften beschränken. Derartige Überprüfungen sind einfacher und kostengünstiger als eine erneute, vollständige Fehlerbetrachtung.

Insgesamt verbindet das neue Sicherheitsschaltgerät somit die Vorzüge eines On-Chip-Redundanz-Systems mit den Vorteilen eines Systems, das mit zwei eigenständig redundanten Signalverarbeitungssystemen aufgebaut ist. Die oben genannte Aufgabe ist damit vollständig gelöst.

In einer bevorzugten Ausgestaltung weist der Stapel ein weiteres Halbleitersubstrat auf.

In dieser Ausgestaltung ist neben dem ersten und dem zweiten Halbleitersubstrat ein weiteres Halbleitersubstrat in dem Stapel angeordnet, welches entweder ähnlich aufgebaut ist wie die anderen Halbleitersubstrate oder aber Strukturen beinhaltet, die anderweitige Funktionen wahrnehmen können. So kann auf einfache Weise eine "System-on-Stack" (SoS) aufgebaut werden, welches die relevanten Funktionen eines Sicherheitsschaltgeräts in einem Chip abbilden kann und gleichzeitig eine strukturelle Aufteilung bereitstellt.

In einer besonders bevorzugten Ausgestaltung weist das erste Halbleitersubstrat eine erste Signalverarbeitungseinheit, das zweite Halbleitersubstrat eine zweite Signalverarbeitungseinheit und das weitere Halbleitersubstrat eine Steuer- und Speicherstruktur auf, wobei die erste und die zweite Signalverarbeitungseinheit mit der Steuer- und Speicherstruktur gekoppelt sind.

In dieser Ausgestaltung ist die weitere Halbleiterschicht als Steuer- und Speicherstruktur ausgebildet, die beispielsweise einen Komparator, einen "Watchdog", Schnittstellen zur Peripherie oder RAM/ROM-Speicher beinhalten kann. Durch diese Maßnahme können die Signalverarbeitungseinheiten besonders einfach aufgebaut werden und ggf. auf ein Standarddesign zurückgreifen, wobei gemeinsam genutzte Elemente auf dem weiteren Halbleitersubstrat angeordnet sein können. So lassen sich verschiedene Komponenten zu einem "System-On-Stack " kombinieren, um robuste und kostengünstige Sicherheitsschaltgeräte zu realisieren. Darüber hinaus können durch die Anordnung der weiteren Elemente eines Sicherheitsschaltgerätes innerhalb des einstückigen Bauteils weitere Fehlerursachen von vorneherein zuverlässig ausgeschlossen werden. Insbesondere Verkabelungsfehler, wie sie bei der Verkabelung von diskreten Bauteilen mit Leiterkabeln auftreten können, können so vermieden werden.

In einer weiteren besonders bevorzugten Ausgestaltung ist das weitere Halbleitersubstrat in dem Stapel zwischen dem ersten und dem zweiten Halbleitersubstrat angeordnet.

In dieser Ausgestaltung bedeckt das erste Halbleitersubstrat eine erste Seite des Weiteren Halbleitersubstrats und das zweite Halbleitersubstrat eine der ersten Seite gegenüberliegende Seite des weiteren Halbleitersubstrats. Mit anderen Worten ist der Stapel wie ein Schichtsystem aufgebaut, wobei das weitere Halbleitersubstrat eine mittlere Schicht bildet. Vorzugsweise bedecken das erste und das zweite Halbleitersubstrat das weitere Halbleitersubstrat auf der jeweiligen Seite vollständig. Durch diese Maßnahme ist die mittlere Schicht, insbesondere darauf angeordnete Speicherstrukturen, physikalisch durch die erste und die zweite Halbleitersubstratschicht geschützt, so dass Teilchen- und Welleneinflüsse auf die mittlere Schicht minimiert werden können. Vorteilhaft können so "empfindliche" RAM-Speicher zuverlässig vor äußeren Einflüssen geschützt werden.

In einer weiteren Ausgestaltung sind das erste und das zweite Halbleitersubstrat voneinander räumlich beabstandet im Stapel angeordnet.

In dieser Ausgestaltung liegen das erste und zweite Halbleitersubstrat also nicht unmittelbar aufeinander im Stapel, sondern sind räumlich voneinander getrennt. Diese Maßnahme hat den Vorteil, dass die integrierten Halbleiterstrukturen der Halbleitersubstrate beabstandet voneinander angeordnet werden können, wodurch ein Übersprechen von Signalen oder Kurzschlüsse zwischen den Verarbeitungseinheiten physikalisch vermieden werden.

In einer weiteren Ausgestaltung sind zwischen dem ersten und dem zweiten Halbleitersubstrat eine Isolationsschicht und/oder ein weiteres Halbleitersubstrat angeordnet.

Diese Maßnahme hat den Vorteil, dass das erste und das zweite Halbleitersubstrat in einem definierten Abstand zueinander angeordnet werden können. So kann eine Isolationsschicht eingefügt werden, um die beiden Halbleitersubstrate elektrisch voneinander zu entkoppeln, wodurch ein Übersprechen und Kurzschlüsse zwischen den integrierten Halbleiterstrukturen ausgeschlossen werden können. Insbesondere kann auch ein weiteres Halbleitersubstrat zwischen dem ersten und dem zweiten Halbleitersubstrat angeordnet sein, welches Funktionen wahrnimmt, die von den Halbleiterschaltkreisen auf dem ersten Halbleitersubstrat und/oder dem zweiten Halbleitersubstrat verwendet werden. Es versteht sich, dass auch eine Kombination bestehend aus Isolationsschichten und Halbleitersubstraten als Zwischenschicht verwendet werden kann, um die genannten Vorteile zu verbinden.

In einer weiteren Ausgestaltung weist der Stapel mindestens zwei Halbleitersubstrate und mindestens ein vertikales Kontaktelement auf, wobei das vertikale Kontaktelement die mindestens zwei Halbleitersubstrate elektrisch verbindet.

In dieser Ausgestaltung sind die intergierten Halbleiterstrukturen auf unterschiedlichen Halbleitersubstraten angeordnet, jedoch über vertikale Kontaktelement innerhalb des Stapels verbindbar. Diese Maßnahme besitzt den Vorteil, dass die Halbleiterschaltkreise auf dem ersten und dem zweiten Halbleitersubstrat auf einfache Weise miteinander verbunden werden können, um beispielsweise eine Interprozess-Kommunikation zu ermöglichen und eine Überwachung der einzelnen Signalverarbeitungskanäle durch den jeweils anderen Signalverarbeitungskanal zu ermöglichen.

Alternativ hierzu wäre es auch denkbar, die redundanten Signalverarbeitungskanäle extern, d.h. außerhalb der Halbleitersubstrate, zum gegenseitigen Datenaustausch miteinander zu verbinden. Demgegenüber besitzt die bevorzugte Maßnahme jedoch den Vorteil, dass eine Fehlerbetrachtung zum gegenseitigen Datenaustausch ebenfalls nur einmalig bei der Entwicklung des Chipstapels durchgeführt werden muss und Fehler bei der Installation des Signalverarbeitungskanals reduziert werden können. Darüber hinaus ist ein interner Datenaustausch über vertikale Kontaktelemente schneller und freier von störenden Umwelteinflüssen möglich.

In einer weiteren Ausgestaltung weist das erste Halbleitersubstrat eine erste Signalverarbeitungseinheit und das zweite Halbleitersubstrat eine zweite Signalverarbeitungseinheit auf, wobei die erste Signalverarbeitungseinheit einen zur zweiten Signalverarbeitungseinheit zeitlich verschobenen Arbeitszyklus aufweist.

In dieser Ausgestaltung weisen die erste und die zweite Signalverarbeitungseinheit einen Prozessortakt auf, der einen festen, vorzugsweise gleichen, Arbeitszyklus der Signalverarbeitungseinheiten definiert. Der Arbeitszyklus der ersten Signalverarbeitungseinheit ist dabei gegenüber dem Arbeitszyklus der zweiten Signalverarbeitungseinheit wenigsten um einen Takt versetzt. Diese Maßnahme hat den Vorteil, dass auf einfache Weise Fehler aufgrund gemeinsamer Ursache besser erkannt werden können. So können synchron auftretende Fehler, wie beispielsweise eine gleichzeitige Spannungsspitze in beiden Signalverarbeitungskanälen, durch den zeitlichen Versatz bei der Verarbeitung der Signale durch die Signalverarbeitungseinheiten aufgedeckt werden. Vorzugsweise arbeiten beide Signalverarbeitungseinheiten mit einem einheitlichen Prozessortakt, der für den zeitlichen Versatz um eine Phase verschoben ist.

Das Sicherheitsschaltgerät weist eine erste Spannungsversorgung und eine zweite Spannungsversorgung, die von der ersten getrennt ist, auf, wobei die erste Spannungsversorgung dem ersten Halbleitersubstrat zugeordnet ist und die zweite Spannungsversorgung dem zweiten Halbleitersubstrat zugeordnet ist.

In dieser Ausgestaltung werden das erste und das zweite Halbleitersubstrat jeweils von einer getrennten Spannungsversorgung versorgt, die darüber hinaus vorzugsweise über eine eigene Überwachungsschaltung verfügt, um sie vor Überspannungen zu schützen. Diese Maßnahme hat den Vorteil, dass für jedes Halbleitersubstrat mit seinen integrierten Schaltkreisen je eine eigene Spannungsversorgung zur Verfügung steht und das Risiko eines Ausfalls aufgrund einer fehlerhaften Spannungsversorgung oder einer unerwarteten Überspannung minimiert werden kann. Durch diese Maßnahme wird die Fehlersicherheit des Sicherheitsschaltgerätes weiter erhöht.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Figur 1: eine vereinfachte Darstellung eines bevorzugten Ausführungsbeispiels des neuen Sicherheitsschaltgeräts an einer Maschinenanlage,
- Figur 2: eine perspektivische Darstellung eines Ausführungsbeispiels eines einstückigen elektronischen Bauteils des neuen Sicherheitsschaltgeräts,
- Figur 3: eine schematische Darstellung eines Ausführungsbeispiels eines Chipstapels des neuen Sicherheitsschaltgeräts, und
- Figur 4: eine schematische Darstellung eines bevorzugten Ausführungsbeispiels eines Chipstapels des neuen Sicherheitsschaltgeräts.

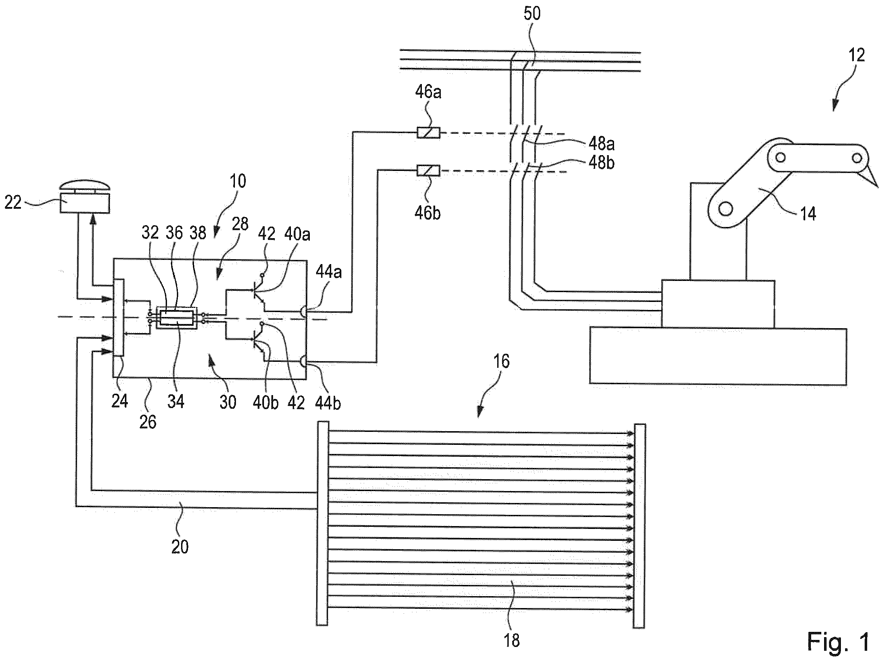

In der Fig. 1 ist ein Ausführungsbeispiel des neuen elektronischen Sicherheitsschaltgeräts in der Gesamtheit mit der Bezugsziffer 10 bezeichnet.

Das Sicherheitsschaltgerät ist in diesem Ausführungsbeispiel einer technischen Anlage 12 zugeordnet, die hier beispielhaft durch einen Roboter 14 angedeutet ist. Von dem Roboter 14 geht im Arbeitsbetrieb eine Gefahr für eine Person aus, welche sich im Arbeitsbereich des Roboters 14 aufhält. Aus diesem Grunde ist der Arbeitsbereich des Roboters 14 mit einer Schutzeinrichtung 16 gegenüber unberechtigtem Zugang abgesichert. Die Schutzeinrichtung 16 ist in dem hier dargestellten Fall eine berührungslos wirkende Schutzeinrichtung in Form eines Lichtgitters 18, das so im Zugangsbereich zur technischen Anlage 12 angeordnet ist, dass eine Person oder ein Gegenstand, der in den Zugangsbereich eindringt, mindestens einen von einer Vielzahl von Lichtstrahlen unterbricht, die zwischen einer Sender-/Empfängerkombination des Lichtgitters 18 ausgesandt werden.

Über Leitungen 20 ist das Lichtgitter 18 mit dem Sicherheitsschaltgerät 10 verbunden und führt diesem Eingangssingale in Abhängigkeit des aktuellen Zustands zu. Bei einer aktiven Schutzeinrichtung, wie das hier dargestellte Lichtgitter 18, werden redundante Eingangssignale, sogenannte OSSD-Signale, von der Schutzeinrichtung selbstständig erzeugt und zum Sicherheitsschaltgerät 10 übertragen. Passive Schutzeinrichtungen, wie der hier dargestellte Not-Aus-Taster 22, bekommen in der Regel ein Ausgangssignal von der Sicherheitssteuerung 10 zugeführt und schleifen dieses als Eingangssignal zurück an das Sicherheitsschaltgerät 10.

Das Sicherheitsschaltgerät 10 besitzt in diesem Ausführungsbeispiel eine E/A-Einheit 24 mit einer Vielzahl von Geräteanschlüssen zum Aufnehmen der Eingangssignale und zum Bereitstellen von Ausgangssignalen. In einigen Ausführungsbeispielen sind diese Geräteanschlüsse Anschlussklemmen, die an einer Gehäuseseite des Gehäuses 26 des Sicherheitsschaltgeräts 10 angeordnet sind, beispielsweise in Form von Federzugklemmen oder Schraubklemmen. In anderen Ausführungsbeispielen können die Geräteanschlüsse Stecker oder Buchsen sein, die mehrere Kontaktelemente beinhalten, wobei jeweils ein Pin einen Geräteanschluss bildet. Häufig werden M8-Buchsen mit fünf Kontaktpins für den Anschluss von Schutzeinrichtungen oder anderen Sensoren auf Feldebene verwendet.

In dem hier dargestellten Fall erzeugt das Lichtgitter 18 zwei redundante Eingangssignale (OSSD1, OSSD2), die über getrennte Leitungen 20 dem Sicherheitsschaltgerät 10 zugeführt werden. In anderen Ausführungsbeispielen können die Eingangssignale ebenso über zwei Adern eines einzelnen Verbindungskabels übertragen werden. Ebenso ist es denkbar, dass die Eingangssignale über einen Bus, beispielsweisen einen sicheren Feldbus, zum Sicherheitsschaltgerät 10 übertragen werden. In solch einem Fall ist die E/A-Einheit 24 als ein Kommunikationsmodul ausgebildet, welches das Protokoll des verwendeten Busses implementiert. Die Eingangssignale können von dem Kommunikationsmodul ausgelesen und dem Sicherheitsschaltgerät 10 als redundantes Eingangssignalpaar bereitgestellt werden.

Das Sicherheitsschaltgerät 10 besitzt in dem vorliegenden Ausführungsbeispiel einen ersten Signalverarbeitungskanal 28 und einen zweiten Signalverarbeitungskanal 30, die redundant zueinander ausgelegt sind, und dazu ausgebildet sind, die Eingangssignale einer Schutzeinrichtung 16, 22 redundant zueinander auszuwerten. Die beiden Signalverarbeitungskanäle 28, 30 sind zumindest teilweise mithilfe von integrierten Halbleiterstrukturen aufgebaut, wobei die integrierte Halbleiterstruktur des ersten Signalverarbeitungskanals 28 auf einem ersten Halbleitersubstrat 32 und die integrierte Halbleiterstruktur des zweiten Signalverarbeitungskanals 30 auf einem zweiten Halbleitersubstrat 34 angeordnet sind. Das erste und zweite Halbleitersubstrat 32, 34 sind zu einem Chipstapel 36 zusammengefasst und zu einem einstückigen elektronischen Bauteil 38 in an sich bekannter Weise vergossen.

In bevorzugten Ausführungsbeispielen sind alle wesentlichen Bestandteile eines Signalverarbeitungskanals mithilfe der integrierten Halbleiterstrukturen auf einem Halbleitersubstrat aufgebaut und die Halbleitersubstrate zu einem Stapel 36 zusammengefügt. So beinhaltet ein Chipstapel 36 vorzugsweise Ein- und Ausgänge, zentrale Verarbeitungseinheiten, Speicher, Komparatoren und A/D-Wandler, mit deren Hilfe die Eingangssignale fehlersicher verarbeitet werden können. Alternativ oder ergänzend können die Signalverarbeitungskanäle 28, 30 zudem weitere diskrete Bauelemente aufweisen, die nicht als integrierte Halbleiterstruktur ausgebildet sind. In dem hier dargestellten Fall besitzt das Sicherheitsschaltgerät 10 beispielsweise je Signalverarbeitungskanal 28, 30 ein Schaltelemente 40a, 40b, die je in der Lage sind, ein hohes Spannungspotential 42 zu einem Geräteanschluss 44a, 44b des Sicherheitsschaltgerätes 10 durchzuschalten, um einen Stromfluss zu einem Schütz 46a, 46b zu ermöglichen, oder diesen Stromfluss zu unterbrechen. Damit kann jedes Schaltelement 40 einen Aktor, wie einen Schütz 46a, 46b, oder ein Magnetventil abschalten.

Die Schütze 46a, 46b besitzen jeweils Arbeitskontakte 48a, 48b. Die Arbeitskontakte 48a, 48b sind hier in Reihe zueinander in einem Stromversorgungspfad von einer Stromversorgung 50 zum Roboter 14 angeordnet. Sobald das Sicherheitsschaltgerät 10 die Schütze 46a, 46b abschaltet, fallen die Kontakte 48a, 48b ab und die Stromversorgung 50 für den Roboter 14 wird abgeschaltet. Den einschlägigen Fachleuten ist klar, dass eine solche "radikale" Abschaltung hier beispielhaft beschrieben ist. Abweichend hiervon können bei einer Sicherheitsanforderung auch lediglich Teile des Roboters 14 abgeschaltet werden, wie etwa die gefährlichen Antriebe, während andere Teile des Roboters 14 funktionsbereit bleiben. Auch ein verzögertes Abschalten ist denkbar, damit der Roboter 14 ggf. vor dem Abschalten der Antriebe kontrolliert abgebremst werden kann.

Es versteht sich, dass Sicherheitsschaltgeräte nicht auf die hier dargestellte Ausführungsform beschränkt sind. Sicherheitsschaltgeräte im Sinne der Erfindung umfassen beispielsweise auch konfigurierbare Sicherheitsschaltgeräte, programmierbare Sicherheitssteuerungen oder sichere Module einer Standardsteuerung.

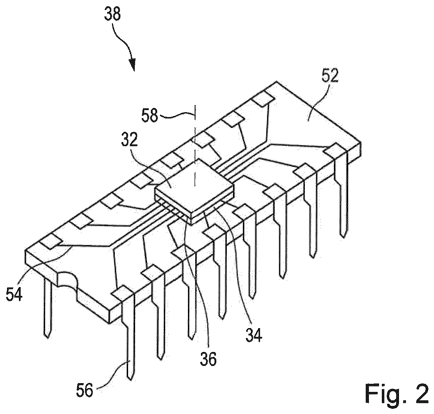

In der Fig. 2 ist ein Ausführungsbeispiel eines einstückigen elektronischen Bauteils 38 in einer stark vereinfacht Darstellung gezeigt. Gleiche Bezugszeichen bezeichnen hierbei gleiche Teile wie zuvor in der Fig. 1.

Das einstückige elektronische Bauteil 38 ist hier als Mikrochip mit einem Dual-Inline-Pack-age-(DIP)-Gehäuse realisiert. Innerhalb des DIP-Gehäuses ist ein Chipstapel 36 mit einem ersten Halbleitersubstrat 32 und einem zweiten Halbleitersubstrat 34 auf einem Träger 52 angeordnet. Über geeignete Verbindungstechnik, wie Bonden, sind die Halbleiterstrukturen auf den beiden Halbleitersubstraten 32, 34 mit Leiterbahnen 54 verbunden. Die Leiterbahnen 54 sind wiederum mit Kontaktpins 56 verbunden, über die die Halbleiterstrukturen von außen kontaktierbar sind. Über die Kontaktpins 56 können beispielsweise die Eingangssignale an die integrierten Halbleiterstrukturen auf den Halbleitersubstraten 32, 34 herangeführt bzw. die Ausgangssignale nach außen geführt werden.

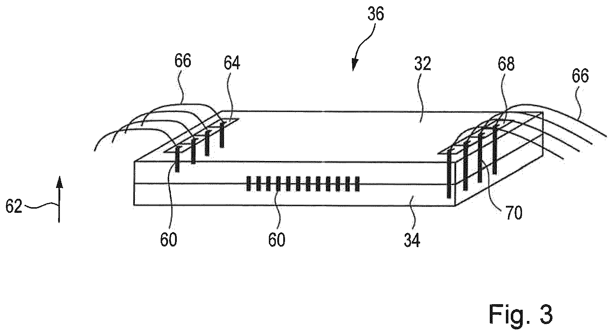

Abweichend von herkömmlichen elektronischen Bauteilen sind bei dem neuen Sicherheitsschaltgerät mindestens zwei Halbleitersubstrate 32, 34 innerhalb des elektronischen Bauteils 38 angeordnet. Die Halbleitersubstrate 32, 34 sind vorzugsweise deckend übereinander gestapelt, so dass sie einen quaderförmigen Stapel 36 bilden. Jedes Halbleitersubstrat beinhaltet dabei eine eigenständige Halbleiterstruktur, die einen Signalverarbeitungskanal abbildet. Eine Kopplung der integrierten Halbleiterstrukturen des ersten Halbleitersubstrats 32 mit den Halbleiterstrukturen des zweiten Halbleitersubstrats 34 kann innerhalb des elektronischen Bauteils 38 über die Leiterbahnen 54 auf dem Träger 52 innerhalb des DIP-Gehäuses realisiert werden, oder aber über eine Verbindung zwischen den Anschlusspins 56 außerhalb des Gehäuses. Besonders bevorzugt werden die integrierten Halbleiterstrukturen jedoch bereits innerhalb des Stapels 36 miteinander gekoppelt. Wie im Folgenden anhand der Fig. 3 näher erläutert wird, werden hierzu vertikale Verbindungen parallel zur Hochachse 58 des Chipstapels 36 in den Halbleitersubstraten 32, 34 integriert.

Das DIP-Gehäuse wird am Ende der Fertigung mit einem hier nicht darstellen Deckelteil versehen. Das Deckelteil wird über den Leiterbahnen 54 und den Chipstapel 36 aufgebracht. Die Leiterbahnen 54 und den Chipstapel 36 sind somit im Inneren des DIP-Gehäuses fest verschlossen angeordnet und so vor Veränderungen und Umwelteinflüssen sicher geschützt. Ebenso ist eine nachträgliche Änderung der Struktur der Signalverarbeitungskanäle oder deren Koppelung nicht mehr oder nur eingeschränkt möglich.

Es versteht sich, dass ein DIP-Gehäuse, wie hier dargestellt, nur eine mögliche Gehäuseform ist, in die ein hier beschriebener Chipstapel 36 angeordnet sein kann und nicht einschränkend zu verstehen ist. Andere gängige Gehäuseformen, wie beispielsweise ein Small-Outline-(SO)-Gehäuse in SMD-Technik, sind für die Konstruktion eines hier vorgeschlagenen einstückigen elektronischen Bauteils ebenso denkbar. Eine Verpackung des ungehäusten Chipstapels 36 könnte darüber hinaus in einem andere Ausführungsbeispiel auch durch eine Vergussmasse realisiert werden, die den Chipstapel 36 umhüllt und sich formschlüssig um die Halbleitersubstrate 32, 34 legt. Durch die Verpackung in einem Gehäuse und/oder durch eine Vergussmasse entsteht ein integriertes, mehrkanaliges Logikbauteil, das beispielsweise in automatisierten Bestückungsprozessen auf einer Leiterplatte positioniert werden kann.

Fig. 3 zeigt ein Ausführungsbeispiel eines Chipstapels 36 in einer vereinfachten schematischen Darstellung. Der Chipstapel 36 beinhaltet in diesem Ausführungsbeispiel ein erstes und ein zweites Halbleitersubstrat 32, 34, die übereinander zu einem Stapel angeordnet sind. Auf den Halbleitersubstraten 32, 34 sind jeweils Halbleiterstrukturen angeordnet, die als monolithischer Schaltkreis eine elektronische Schaltung mit aktiven und passiven Bauelementen abbilden. In dem hier dargestellten Fall sind auf dem ersten Halbleitersubstrat 32 eine elektronische Schaltung eines ersten Signalverarbeitungskanals 28 angeordnet und auf dem zweiten Halbleitersubstrat 34 eine elektronische Schaltung eines zweiten Signalverarbeitungskanals 30.

Bei der Fertigung können die Halbleitersubstrate 32, 34 zunächst unabhängig voneinander hergestellt und mit einer entsprechenden Halbleiterstruktur versehen werden. Denkbar ist auch, dass beide Halbleitersubstrate 32, 34 zunächst ein Teil eines gemeinsamen Basis-Halbleitersubstrats sind, auf dem gleichzeitig mehrere Halbleiterstrukturen für verschiedene Chips ausgebildet werden. Anschließend wird das Basis-Halbleitersubstrat in mehrere einzelne Chips zerteilt, die wiederum zu einem Chipstapel übereinander gesetzt werden. Zur Vermeidung von Common-Cause-Fehlern kommen die einzelnen Halbleitersubstrate des Chipstapels 36 jedoch vorzugsweise aus unterschiedlichen Fertigungstranchen.

Der Chipstapel 36 ist nicht auf die Verwendung bestimmter Halbleitersubstrate und Ausgangsmaterialien beschränkt. Neben gängigen Siliziumhalbleitern können bspw. auch organische Halbleiter, sogenannte Plastikelektronik, verwendet werden. Vorzugsweise weist der Chipstapel 36 sehr dünne Halbleitersubstrate auf, wobei durch die Stapelung eine ausreichende Stabilität erreicht werden kann. Ebenso müssen die Halbleitersubstrate nicht zwangsläufig identisch sein. Denkbar ist auch eine Konstruktion mit Halbleitersubstraten mit unterschiedlichen Materialdicken. Beispielsweise könnte eine Basisschicht aus einem dickeren Halbleitersubstrat gebildet sein als die weiteren Schichten des Stapels 36, um eine stabile Basis für den Stapel 36 bereitzustellen.

Die integrierten Halbleiterstrukturen auf den Halbleitersubstraten sind zunächst unabhängig voneinander und werden erst nach dem Stapeln miteinander gekoppelt. Die Koppelung erfolgt extern oder innerhalb des Stapels durch vertikale Kontaktelemente 60. In dem hier dargestellten Fall weist der Chipstapel 36 für die Kopplung mehrere vertikale Kontaktelemente 60 auf. Die vertikalen Kontaktelemente 60 sind Leiter die parallel zur Stapelrichtung 62 des Chipstapels 36 ausgebildet sind. Die vertikalen Kontaktelemente 60 werden auch als "Through Silicon Vias" (TSV) bezeichnet und stellen eine elektrische Verbindung zwischen zwei Halbleitersubstraten her. Die vertikalen Kontaktelemente 60 sind Löcher oder Aussparungen in den Halbleitersubstraten, die durch Bohrungen oder spezielle Ätzverfahren erzeugt werden. Die Löcher in den Halbleitersubstraten kontaktieren die Halbleiterstrukturen im Halbleitersubstrat und reichen zumindest an einer Seite des Halbleitersubstrats bis an die Oberfläche. Die Löcher sind mit leitfähigem Material, wie Kupfer oder Aluminium, gefüllt und werden beim Stapel der Halbleitersubstrate bündig übereinander angeordnet, so dass das leitfähige Material in einem Loch des ersten Halbleitersubstrats 32 mit dem leitfähigen Material eines weiteren Lochs im zweiten Halbleitersubstrat 34 in elektrischen Kontakt tritt. Auf diese Weise können direkte Verbindung zwischen den Halbleiterstrukturen des ersten Halbleitersubstrats 32 und des zweiten Halbleitersubstrats 34 erzeugt werden, wodurch eine nahezu latentzfreie Interprozesskommunikation zwischen den beiden Halbleiterstrukturen möglich ist.

Es versteht sich, dass alternativ eine Verbindung zwischen den Halbleitersubstraten 32, 34, wie zu vor in Bezug auf Fig. 2 beschrieben, auch außerhalb des Chipstapels 36 erstellen werden kann. Hierzu werden die Kontakte der Halbleiterstrukturen auf den Halbleitersubstraten nach außen geführt und vorzugweise noch innerhalb des einstückigen Bauteils miteinander verbunden.

Zur Kontaktierung der Halbleiterstrukturen des ersten Halbleitersubstrats 32 sind hier illustrativ auf der Oberfläche des ersten Halbleitersubstrats 32 erste Kontaktflächen 64 angeordnet, die über Bonddrähte 66 in an sich bekannter Weise kontaktierbar sind. In diesem bevorzugten Ausführungsbeispiel sind darüber hinaus zweite Kontaktflächen 68 auf der Oberfläche des ersten Halbleitersubstrats 32 angeordnet, über die die Halbleiterstrukturen des zweiten Halbleitersubstrats 34 kontaktierbar sind. Die zweiten Kontaktflächen 68 sind hierzu über weitere vertikale Kontaktelement 70 in der zuvor beschriebenen Weise mit den Halbleiterstrukturen des zweiten Halbleitersubstrats 34 verbunden. Vorteilhaft können so die gängigen Verfahren zur Kontaktierung von ungehäusten Halbleiterchips auch für die Kontaktierung des ungehäusten Chipstapels 36 genutzt werden. Alternativ oder ergänzend können auch Kontaktflächen auf dem zweiten Halbleitersubstrat ausgebildet sein, die nach außen kontaktierbar sind.

Alternativ zu den Bonddrähten 66 sind andere Möglichkeiten zur Kontaktierung des ungehäusten Chipstapels 36 denkbar, wie beispielsweise eine Flip-Chip-Montage, auch bekannt als controlled collapse chip connection (C4). Bei der Flip-Chip-Montage wird der ungehäuste Chipstapel 36 direkt, ohne weitere Anschlussdrähte, mit der aktiven Kontaktierungsseite eines der Halbleitersubstrate 32, 34 nach unten hin auf einem Träger montiert. Dies führt zu besonders geringen Abmessungen des Gehäuses und kurzen Leiterlängen. Kurzschlüsse durch sich berührende Bonddrähte können so besonders einfach und effektiv ausgeschlossen werden. Darüber hinaus erfolgt bei der Flip-Chip-Bondtechnik die Verbindung aller Kontakte gleichzeitig, wodurch die Fertigungszeit verringert werden kann. Um die Chips zu bonden, kann neben Löten und leitfähigem Kleben auch Pressschwei-ßen (thermode bonding) als Fügeverfahren angewendet werden. Die Flip-Chip-Montage hat darüber hinaus den Vorteil, dass in der Regel beim Kontaktieren nur eine geringe mechanische Belastung auf den zu kontaktierenden Chip ausgeübt wird. So können auch sehr dünne und poröse Halbleitersubstrate 32, 34 zur Erstellung des Chipstapels 36 eingesetzt werden. Ein mit dem Flip-Chip-Verfahren montierte Chip wird in der Regel nicht mehr separat umhäust, sondern mit einer Legierung oder Füllmasse versehen, zum Schutz vor Umwelteinflüssen und Veränderungen. Eine derartiges "Gehäuse" ist besonders kostengünstig in der Fertigung.

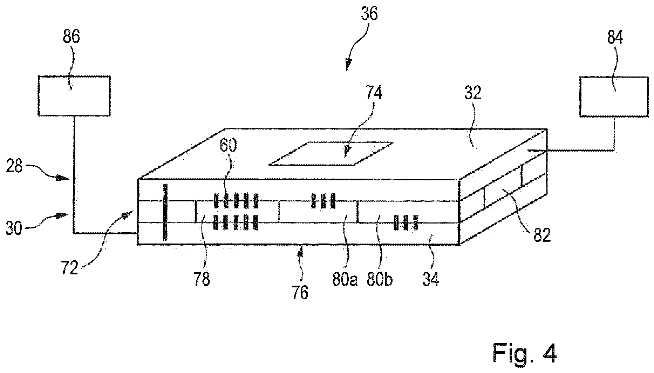

Fig. 4 zeigt ein besonders bevorzugtes Ausführungsbeispiel eines Chipstapels 36 in einer vereinfachten schematischen Darstellung. Der Chipstapel 36 wird in diesem Ausführungsbeispiel aus einem ersten Halbleitersubstrat 32, einem zweiten Halbleitersubstrat 34 sowie einem weiteren Halbleitersubstrat 72 gebildet. Das erste Halbleitersubstrat 32 und das zweite Halbleitersubstrat 34 sind im Wesentlichen identisch aufgebaut. So beinhaltet das erste Halbleitersubstrat 32 als integrierte Halbleiterstruktur eine erste Signalverarbeitungseinheit 74 und das zweite Halbleitersubstrat 34 als integrierte Halbleiterstruktur eine zweite Signalverarbeitungseinheit 76.

In einem besonders bevorzugten Ausführungsbeispiel sind die erste und zweite Signalverarbeitungseinheit 74, 76 funktionsgleich jedoch diversitär zueinander aufgebaut, um das Risiko von Fehlern gemeinsamer Ursache bei der Signalverarbeitung verringern zu können. Die erste Signalverarbeitungseinheit 74 ist dem ersten Signalverarbeitungskanal 28 zugeordnet und die zweite Signalverarbeitungseinheit 76 ist dem zweiten Signalverarbeitungskanal 30 zugeordnet. Die erste und die zweite Signalverarbeitungseinheit 74, 76 verarbeiten parallel das Eingangssignal und erzeugen unabhängig voneinander ein Ausgangssignal in Abhängigkeit des Eingangssignals. Vorzugsweise sind auf dem ersten und dem zweiten Halbleitersubstrat 32, 34 ausschließlich die erste und zweite Signalverarbeitungseinheit 74, 76 angeordnet.

Die erste und zweite Signalverarbeitungseinheit 74, 76 arbeiten als fehlertolerantes System zusammen und verarbeiten parallel das Eingangssignal. Eine solche Redundanz wird auch als Dual Modular Redundancy (DMR) bezeichnet und stellt eine hohe Robustheit gegenüber Fehlern bereit. DMR-Systeme können Fehler zuverlässig erkennen, jedoch nicht ohne weiteres feststellen, in welchem Kanal ein Fehler aufgetreten ist. Aufgrund dessen könnte in einem anderen Ausführungsbeispiel das Sicherheitsschaltgerät mindestens eine weitere Signalverarbeitungseinheit aufweisen, vorzugsweise ebenfalls integriert in dem einstückigen elektronischen Bauteil, wodurch eine dreifache Redundanz gebildet wird. Systeme mit dreifacher Redundanz werden auch als Triple Modular Redundancy (TMR) Systeme bezeichnet und beispielsweise in Luftfahrzeugen oder bei Systemen mit hohen Anforderungen an die Verfügbarkeit eingesetzt. TMR-Systeme können Fehler nicht nur erkennen, sondern basierend auf dem Mehrheitsprinzip auch beheben.

Die Signalverarbeitungseinheiten 74, 76 werden in diesem Ausführungsbeispiel ferner je mit einem eigenen Prozessortakt betrieben. Vorzugsweise sind der Prozessortakt der ersten und zweiten Signalverarbeitungseinheiten 74, 76 zueinander phasenverschoben. So bearbeiten die Signalverarbeitungseinheiten 74, 76 das Eingangssignal parallel jedoch mit einem geringen zeitlichen Versatz. Auf diese Weise kann die Fehlersicherheit weiter erhöht werden, da eine auf beiden Kanälen gleichzeitig auftretende Störung, wie beispielsweise eine kurze Spannungsspitze zu verlässig erkannt werden kann.

Darüber hinaus ist das weitere Halbleitersubstrat 72 ist in diesem bevorzugten Ausführungsbeispiel zwischen dem ersten Halbleitersubstrat 32 und dem zweiten Halbleitersubstrat 34 angeordnet. Das weitere Halbleitersubstrat 72 weist eine oder mehrere getrennte integrierte Halbleiterstrukturen auf, die eine Steuer- und Speicherstruktur bilden, die mit den integrierten Halbleiterstrukturen des ersten Halbleitersubstrats 32 und/oder des zweiten Halbleitersubstrats 34 gekoppelt sein kann. Die Steuer- und Speicherstruktur beinhaltet in dem hier dargestellten Beispiel einen Komparator 78, Speicherbereiche 80a, 80b und einen "Watchdog" 82, die bei der Signalverarbeitung unterstützen oder eine ordnungsgemäße Funktion der Signalverarbeitungseinheiten 74, 76 überwachen können.

Der Komparator 78 ist beispielsweise ein elektronischer Schaltkreis, der zwei digitale Werte vergleicht. Der "Watchdog" 82 ist ein integrierter Schaltkreis, der einem Komplettausfall des elektronischen Bauteils durch Softwareversagen zuvorzukommen kann. So ist der "Watchdog" beispielsweise als Zähler ausgebildet, der in regelmäßigen Abständen von der Software auf einen bestimmten Wert gesetzt wird und hardwareseitig kontinuierlich dekrementiert wird. Sollte der Zähler den Wert 0 erreichen, ist von einem Versagen der Software auszugehen und der "Watchdog" führt eine vorbestimmte Reaktion aus, die hier insbesondere zum Auslösen der Sicherheitsfunktion des Sicherheitsschaltgeräts führt. Die Speicherbereich 80a, 80b können beispielweise Arbeitsspeicher für die Verarbeitungseinheiten 74, 76 oder Festwertspeicher mit hinterlegten Parametern des Sicherheitsschaltgeräts sein.

Es versteht sich, dass das weitere Halbleitersubstrat 72, wie hier dargestellt, nicht zwangsläufig zwischen dem ersten und dem zweiten Halbleitersubstrat 32, 34 in dem Chipstapel 36 angeordnet sein muss. Alternativ könnte das weitere Halbleitersubstrat 72 auch oberhalb oder unterhalb des ersten und des zweiten Halbleitersubstrats 32, 34 angeordnet sein. Die hier dargestellte Anordnung ist besonders bevorzugt, wenn sowohl die erste als auch die zweite Signalverarbeitungseinheit 74, 76 mit der Steuer- und Speicherstruktur des Weiteren Halbleitersubstrats 72 gekoppelt sind. Darüber hinaus ist durch die nahezu vollständige Abdeckung des Weiteren Halbleitersubstrats 72 durch das erste und zweite Halbleitersubstrat 32, 34 ein besonders guter Schutz gegen Strahlen- und Welleneinflüsse möglich.

Eine Kopplung der integrierten Halbleiterstrukturen auf dem ersten, zweiten und dem weiteren Halbleitersubstrat 32, 34, 72 erfolgt, wie zuvor mit Bezug auf Fig. 3 beschrieben, über vertikale Kontaktelemente 60. Ebenso kann eine Kontaktierung der Halbleitersubstrate wie zuvor beschrieben über Kontaktflächen an der Oberfläche und weitere vertikale Kontaktelemente erfolgen (hier nicht dargestellt).

Beispielhaft ist im hier dargestellten Fall der Komparator 78 sowohl mit der ersten Signalverarbeitungseinheit 74 auf dem ersten Halbleitersubstrat 32 und mit der zweiten Signalverarbeitungseinheit 76 auf dem zweiten Halbleitersubstrat 34 gekoppelt. Auf diese Weise können die Signalverarbeitungseinheiten 74, 76 sehr effizient und homogen und mit nahezu beliebiger Breite mit dem Komparator 78 verbunden werden. In einem einzelnen Arbeitszyklus kann so nahezu latenzfrei ein Vergleich von Werten zwischen der ersten Signalverarbeitungseinheit 74 und der zweiten Signalverarbeitungseinheit 76 durchgeführt werden.

Hinsichtlich der Speicherbereiche 80a, 80b können die Kontaktelemente 60 so angeordnet sein, dass die erste Signalverarbeitungseinheit 74 exklusiv auf einen ersten Speicherbereich 80a zugreifen kann und die zweite Signalverarbeitungseinheit 76 exklusiv auf einen zweiten Speicherbereich 80b zugreifen kann. Der "Watchdog" 82 kann wiederum vorteilhaft mit beiden Signalverarbeitungseinheiten 74, 76 verbunden sein und deren korrekte Funktionsweise überwachen. Darüber hinaus ist es auch in dieser Konstellation möglich, dass das erste Halbleitersubstrat 32 unmittelbar mit dem zweiten Halbleitersubstrat 34 verbunden ist, indem ein vertikales Kontaktelement von dem ersten Halbleitersubstrat 32 durch das weitere Halbleitersubstrat 72 zum zweiten Halbleitersubstrat 34 geführt ist.

Abweichend von der Darstellung in Fig. 4 können das erste, zweite und weitere Halbleitersubstrat 32, 34, 72 darüber hinaus unterschiedliche Materialeigenschaften und insbesondere unterschiedliche Substratdicken aufweisen. Vorzugsweise ist das weitere Halbleitersubstrat 72 dicker als das erste und das zweite Halbleitersubstrat 32, 34, um eine Abschirmung der beiden Signalverarbeitungseinheiten 74, 76 voneinander zu ermöglichen. So kann durch ein dickeres weiteres Halbleitersubtrat 72 ein Übersprechen von der ersten Signalverarbeitungseinheit 74 auf die zweite Signalverarbeitungseinheit 76 und umgekehrt physikalisch ausgeschlossen werden.

Schließlich zeigt die Fig. 4 eine erste und eine zweite Spannungsversorgung 84, 86, die getrennt voneinander ausgebildet sind. Die erste Spannungsversorgung 84 ist mit dem ersten Halbleitersubstrat 32 und die zweite Spannungsversorgung 86 ist mit dem zweiten Halbleitersubstrat 34 gekoppelt. Über die erste Spannungsversorgung 84 werden die integrierten Halbleiterstrukturen des ersten Halbleitersubstrat 32 mit einer Versorgungsspannung versorgt und über die zweite Spannungsversorgung 86 werden die integrierten Halbleiterstrukturen des zweiten Halbleitersubstrat 34 mit einer Versorgungsspannung versorgt. Vorzugsweise beinhalten die erste und die zweite Spannungsversorgung 84, 86 je eine Überspannungsüberwachungseinheit (hier nicht dargestellt). Die Überspannungsüberwachungseinheit ist dazu ausgebildet, die Spannungsversorgung im Fall einer Überspannung zu entkoppeln, beispielsweise durch eine Crowbar-Schaltung.

Es versteht sich, dass die in Fig. 4 gezeigten Strukturen in einem anderen Ausführungsbeispiel beliebig miteinander kombiniert werden können. Der Chipstapel 36 ist folglich nicht auf die drei gezeigten Halbleitersubstrate 28, 30, 72 beschränkt. In weiteren vorteilhaften Ausführungen können weitere Halbleitersubstrate und/oder andere Schichten, wie beispielsweise Isolationsschichten, in dem Chipstapel 36 angeordnet sein. Denkbar ist auch, dass eine Vielzahl von den in der Fig. 4 gezeigten Systemen in einem Chipstapel untergebracht ist, um extrem platzsparende, n-kanalige, hochverfügbare und fehlertolerante "Systems-on-Stack" zu realisieren. Insgesamt lassen sich so sehr kosteneffiziente, flexible und sichere Sicherheitsschaltgeräte mit zwei- oder mehrfacher Redundanz erstellen, die den Anforderungen der Sicherheitsanforderungsstufen SIL3 entsprechen können.

Ein Aspekt der vorliegenden Erfindung ist somit ein elektronisches Sicherheitsschaltgerät mit zumindest einem ersten Signalverarbeitungskanal und einem zweiten Signalverarbeitungskanal, denen zur Signalverarbeitung Eingangssignale zuführbar sind und die verarbeitete Ausgangssignale bereitstellen, wobei der erste Signalverarbeitungskanal und der zweite Signalverarbeitungskanal die zugeführten Eingangssignale redundant zueinander verarbeiten, und wobei der erste Signalverarbeitungskanal und der zweite Signalverarbeitungskanal jeweils mit Hilfe integrierter Halbleiterstrukturen aufgebaut sind, wobei der erste Signalverarbeitungskanal monolithisch auf einem ersten Halbleitersubstrat angeordnet ist und der zweite Signalverarbeitungskanal monolithisch auf einem zweiten Halbleitersubstrat angeordnet ist, wobei das erste und das zweite Halbleitersubstrat zu einem Stapel zusammengesetzt sind und ein einstückiges elektronisches Bauteil bilden.

## Patentansprüche

1. Elektronisches Sicherheitsschaltgerät (10) mit zumindest einem ersten Signalverarbeitungskanal (28) und einem zweiten Signalverarbeitungskanal (30), denen zur Signalverarbeitung Eingangssignale zuführbar sind und die dazu eingerichtet sind, verarbeitete Ausgangssignale bereitzustellen,
wobei der erste Signalverarbeitungskanal (28) und der zweite Signalverarbeitungskanal (30) dazu eingerichtet sind, die zugeführten Eingangssignale redundant zueinander zu verarbeiten,
wobei der erste Signalverarbeitungskanal (28) und der zweite Signalverarbeitungskanal (30) jeweils mit Hilfe integrierter Halbleiterstrukturen aufgebaut sind,
wobei der erste Signalverarbeitungskanal (28) monolithisch auf einem ersten Halbleitersubstrat (32) angeordnet ist und der zweite Signalverarbeitungskanal (30) monolithisch auf einem zweiten Halbleitersubstrat (34) angeordnet ist,
**dadurch gekennzeichnet, dass** das erste Halbleitersubstrat (32) und das zweite Halbleitersubstrat (34) zu einem Stapel (36) zusammengesetzt sind und so ein einzelnes, einstückiges elektronisches Bauteil (38) bilden,
wobei der Stapel (36) ein weiteres Halbleitersubstrat (72) aufweist,
wobei das erste Halbleitersubstrat (32) eine erste Signalverarbeitungseinheit (74), das zweite Halbleitersubstrat (34) eine zweite Signalverarbeitungseinheit (76) und das weitere Halbleitersubstrat (72) eine Steuer- und Speicherstruktur aufweist, und
wobei die erste Signalverarbeitungseinheit (74) und die zweite Signalverarbeitungseinheit (76) mit der Steuer- und Speicherstruktur gekoppelt sind.

2. Elektronisches Sicherheitsschaltgerät nach Anspruch 1, wobei die Steuer- und Speicherstruktur einen Komparator (78) zum Abgleichen der ersten Signalverarbeitungseinheit (74) und zweiten Signalverarbeitungseinheit (76) aufweist, und wobei der Komparator (78) unmittelbar mit der ersten (74) und zweiten Signalverarbeitungseinheit (76) verbunden ist.

3. Elektronisches Sicherheitsschaltgerät nach einem der Ansprüche 1 bis 2, wobei das weitere Halbleitersubstrat (72) in dem Stapel (36) zwischen dem ersten (32) und dem zweiten Halbleitersubstrat (34) angeordnet ist.

4. Elektronisches Sicherheitsschaltgerät nach einem der Ansprüche 1 bis 3, wobei das erste Halbleitersubstrat (32) und das zweite Halbleitersubstrat (34) voneinander räumlich beabstandet in dem Stapel (36) angeordnet sind.

5. Elektronisches Sicherheitsschaltgerät nach einem der Ansprüche 1 bis 4, wobei zwischen dem ersten (32) und dem zweiten Halbleitersubstrat (34) eine Isolationsschicht angeordnet ist.

6. Elektronisches Sicherheitsschaltgerät nach einem der Ansprüche 1 bis 5, wobei der Stapel (36) mindestens zwei Halbleitersubstrate (32, 34, 72) und mindestens ein vertikales Kontaktelement (60) aufweist, wobei das vertikale Kontaktelement (60) die mindestens zwei Halbleitersubstrate (32, 34, 72) elektrisch verbindet.

7. Elektronisches Sicherheitsschaltgerät nach einem der Ansprüche 1 bis 6, wobei die erste Signalverarbeitungseinheit (74) einen zur zweiten Signalverarbeitungseinheit (76) zeitlich verschobenen Arbeitszyklus aufweist.

8. Elektronisches Sicherheitsschaltgerät nach einem der Ansprüche 1 bis 7, wobei das elektronische Sicherheitsschaltgerät (10) ferner eine erste Spannungsversorgung (84) und eine von der ersten Spannungsversorgung (84) getrennte zweite Spannungsversorgung (86) aufweist, und wobei die erste Spannungsversorgung (84) dem ersten Halbleitersubstrat (32) zugeordnet ist und die zweite Spannungsversorgung (86) dem zweiten Halbleitersubstrat (34) zugeordnet ist.

## Claims

1. Electronic safety switching device (10), comprising at least a first processing channel (28) and a second signal processing channel (30) to which input signals may be supplied for signal processing, and which provide processed output signals,
wherein the first signal processing channel (28) and the second signal processing channel (30) are configured to process the supplied input signals redundantly with respect to one other,
wherein the first signal processing channel (28) and the second signal processing channel (30) are respectively configured with the aid of integrated semiconductor structures,
wherein the first signal processing channel (28) is arranged monolithically on a first semiconductor substrate (32), and the second signal processing channel (30) is arranged monolithically on a second semiconductor substrate (34),
**characterized in that** the first semiconductor substrate (32) and the second semiconductor substrate (34) are combined into a stack (36) to form a one-piece electronic component (38),
wherein the stack (36) comprises an additional semiconductor substrate (72),
wherein the first semiconductor substrate (32) comprises a first signal processing unit (74), the second semiconductor substrate (34) comprises a second signal processing unit (76), and the additional semiconductor substrate (72) comprises a control and memory structure, and
wherein the first signal processing unit (74) and the second signal processing unit (76) are coupled to the control and memory structure.

2. Electronic safety switching device according to claim 1, wherein the control and memory structure comprises a comparator (78) for cross-checking the first signal processing unit (74) and second signal processing unit (76), wherein the comparator (78) is directly connected to the first signal processing unit (74) and second signal processing unit (76).

3. Electronic safety switching device according to any one of claims 1 to 2, wherein the additional semiconductor substrate (72) is arranged in the stack (36) between the first semiconductor substrate (32) and the second semiconductor substrate (34).

4. Electronic safety switching device according to any one of claims 1 to 3, wherein the first semiconductor substrate (32) and the second semiconductor substrate (34) are arranged spatially distanced from one another in the stack (36).

5. Electronic safety switching device according to any one of claims 1 to 4, wherein an insulation layer is arranged between the first second semiconductor substrate (32) and the second semiconductor substrate (34).

6. Electronic safety switching device according to any one of claims 1 to 5, wherein the stack (36) comprises at least two semiconductor substrates (32, 34, 72) and at least one vertical contact element (60), wherein the vertical contact element (60) electrically connects the at least two semiconductor substrates (32, 34, 72).

7. Electronic safety switching device according to any one of claims 1 to 6, wherein the first signal processing unit (74) comprises an operating cycle which is time-shifted with respect to the second signal processing unit (76).

8. Electronic safety switching device according to any one of claims 1 to 7, wherein the electronic safety switching device (10) further comprises a first voltage supply (84), and a second voltage supply (86) which is separate from the first voltage supply (84), and wherein the first voltage supply (84) is associated with the first semiconductor substrate (32), and the second voltage supply (86) is associated with the second semiconductor substrate (34).

## Revendications

1. Appareil électronique de commutation de sécurité (10) comportant au moins un premier canal de traitement de signaux (28) et un second canal de traitement de signaux (30), auxquels des signaux d'entrée peuvent être amenés pour le traitement de signaux et lesquels sont configurés pour fournir des signaux de sortie traités,
dans lequel le premier canal de traitement de signaux (28) et le second canal de traitement de signaux (30) sont configurés pour traiter les signaux d'entrée amenés de manière redondante les uns par rapport aux autres,
dans lequel le premier canal de traitement de signaux (28) et le second canal de traitement de signaux (30) sont respectivement construits à l'aide de structures semi-conductrices intégrées,
dans lequel le premier canal de traitement de signaux (28) est disposé de manière monolithique sur un premier substrat semi-conducteur (32) et le second canal de traitement de signaux (30) est disposé de manière monolithique sur un deuxième substrat semi-conducteur (34),
**caractérisé en ce que** le premier substrat semi-conducteur (32) et le deuxième substrat semi-conducteur (34) sont assemblés en un empilement (36) et forment ainsi un composant (38) électronique unique en une seule pièce,
dans lequel l'empilement (36) présente un autre substrat semi-conducteur (72),
dans lequel le premier substrat semi-conducteur (32) présente une première unité de traitement de signaux (74), le deuxième substrat semi-conducteur (34) présente une seconde unité de traitement de signaux (76) et l'autre substrat semi-conducteur (72) présente une structure de commande et de stockage, et
dans lequel la première unité de traitement de signaux (74) et la seconde unité de traitement de signaux (76) sont couplées à la structure de commande et de stockage.

2. Appareil électronique de commutation de sécurité selon la revendication 1, dans lequel la structure de commande et de stockage présente un comparateur (78) permettant d'aligner la première unité de traitement de signaux (74) et la seconde unité de traitement de signaux (76), et dans lequel le comparateur (78) est directement connecté à la première (74) et à la seconde unité de traitement de signaux (76).

3. Appareil électronique de commutation de sécurité selon l'une des revendications 1 à 2, dans lequel l'autre substrat semi-conducteur (72) est disposé dans l'empilement (36) entre le premier (32) et le deuxième substrat semi-conducteur (34).

4. Appareil électronique de commutation de sécurité selon l'une des revendications 1 à 3, dans lequel le premier substrat semi-conducteur (32) et le deuxième substrat semi-conducteur (34) sont disposés de manière à être espacés spatialement l'un de l'autre dans l'empilement (36).

5. Appareil électronique de commutation de sécurité selon l'une des revendications 1 à 4, dans lequel une couche isolante est disposée entre le premier (32) et le deuxième substrat semi-conducteur (34).

6. Appareil électronique de commutation de sécurité selon l'une des revendications 1 à 5, dans lequel l'empilement (36) présente au moins deux substrats semi-conducteurs (32, 34, 72) et au moins un élément de contact vertical (60), dans lequel l'élément de contact vertical (60) connecte électriquement les au moins deux substrats semi-conducteurs (32, 34, 72).

7. Appareil électronique de commutation de sécurité selon l'une des revendications 1 à 6, dans lequel la première unité de traitement de signaux (74) présente un cycle de travail décalé dans le temps par rapport à la seconde unité de traitement de signaux (76).

8. Appareil électronique de commutation de sécurité selon l'une des revendications 1 à 7, dans lequel l'appareil électronique de commutation de sécurité (10) présente en outre une première alimentation en tension (84) et une seconde alimentation en tension (86) séparée de la première alimentation en tension (84), et dans lequel la première alimentation en tension (84) est associée au premier substrat semi-conducteur (32) et la seconde alimentation en tension (86) est associée au deuxième substrat semi-conducteur (34).
